# EUROPEAN PATENT SPECIFICATION

(11) **EP 0 468 757 B1**
(45) Date of publication and mention of the grant of the patent: **27.12.1996**
(21) Application number: 91306725.2
(22) Date of filing: 23.07.1991
(51) Int. Cl.: H01P 1/213

(54) **Branching filter**
Abzweigfilter
Filtre de dérivation

(30) Priority: 27.07.1990 JP 197709/90
(43) Date of publication of application: 29.01.1992
(73) Proprietor: Oki Electric Industry Company, Limited, Tokyo 105 (JP)
(72) Inventor: Komazaki, Tomokazu, c/o Oki Electric Ind. Co. Ltd., Minato-ku, Tokyo (JP); Gunji, Katsuhiko, c/o Oki Electric Ind. Co. Ltd., Minato-ku, Tokyo (JP); Onishi, Norio, c/o Oki Electric Ind. Co. Ltd., Minato-ku, Tokyo (JP); Mashimo, Akira, c/o Oki Electric Ind. Co. Ltd., Minato-ku, Tokyo (JP); Ichikawa, Kouichi, c/o Oki Electric Ind. Co. Ltd., Minato-ku, Tokyo (JP)
(74) Representative: Read, Matthew Charles

(56) References cited:
- EP-A- 0 356 572
- WO-A-82/03730
- PATENT ABSTRACTS OF JAPAN vol. 7, no. 58 (E-163)(1203) 10 March 1983& JP-A-57 204 603
- ENTWICKLUNGSBERICHTE DER SIEMENS UND HALSKE AKTIENGESELLSCHAFT. vol. 25, no. 2, November 1962, MUNCHEN DE pages 117 - 122; F.KÜNEMUND ET AL.: 'Veränderbare Bandpässe und Weichen für Zentimeterwellen'

## Description

The present invention relates to a branching filter which may for example be used in telecommunications apparatus such as a radio transmitter and/or receiver apparatus for separating or multiplexing signals having different frequencies on the basis of the frequency bands.

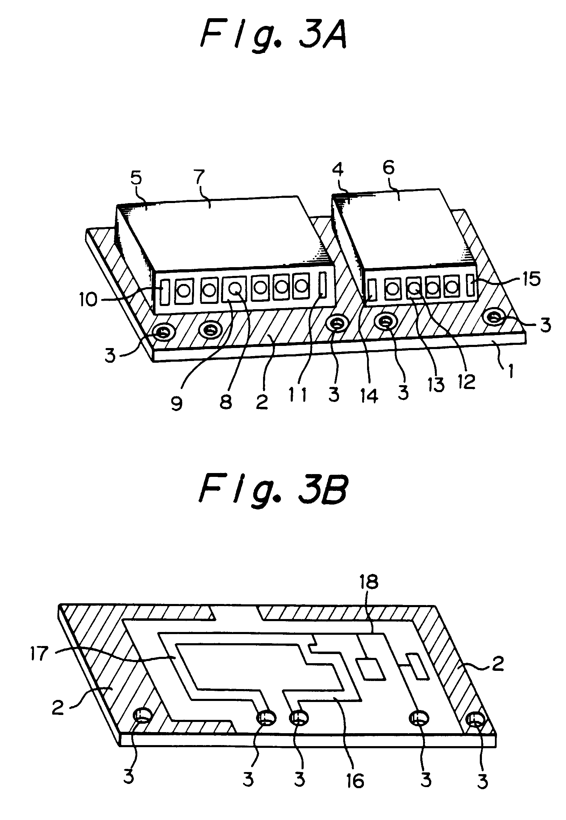

Branch filters are known and examples are described in Japanese patent laid-open publication No. 136104/1987 and 136105/1987. FIGS. 3A and 3B show structures of such a type of conventional branching filter. FIG. 3A is a perspective view of the conventional branching filter, and FIG. 3B is a bottom perspective view of the same. This branching filter is provided with an insulative substrate 1 such as alumina or glass-epoxy resin on a front side and a back side on which are formed a plurality of input/output terminals 3 and grounding conductor pattern 2 by means of thick-film printing, plating processing and the like. The plurality of input/output terminals 3, which are provided on the front side and the back side of the substrate 1, are formed in pairs, and the terminals of each pair are coupled to one another by a through hole from the front side to the back side. A transmitter dielectric filter 6, and receiving dielectric filter 7 are directly mounted on the front side of the substrate 1. The filters 6 and 7 have respective transmission frequency and reception frequency bands with different central frequencies.

The filters 6 and 7, as described in Japanese patent laid-open publication No. 80901/1986, for example, include a block configuration of filter main bodies 4 and 5 each consisting of unitary homogeneous dielectric, a plurality of dielectric resonators 8 and 12 each consisting of a cylindrical configuration of central conductor embedded at regular intervals within the filter main bodies 4 and 5, and a plurality of frequency regulation patterns 9 which are each connected to associated one of the central conductors of the dielectric resonators 8 and 12, formed in one side of the filter main bodies 4 and 5 respectively. At both ends of the filter 6, there are provided input/output terminals 3 and input/output electrodes 14 and 15 connected with the through holes. Also at both ends of the filter 7, there are provided input/output terminals 3 and input/output electrodes 10 and 21 connected with the through holes. The resonant frequency for each of the dielectric resonators is determined by the geometry of the dielectric resonator and a frequency regulation pattern, and the regulation of the resonant frequency may be performed by mechanical or optical technical means, known ***per se****.*

On the back side of the substrate 1, is formed a pair of branching or splitting filter circuits 16 and 17 comprising distributed constant lines such as strip lines, and a low pass filter 18 for spurious signal suppression, by means of thick-film printing, plating processing and the like. The branching filter circuits 16 and 17 are connected through the input/output terminals 3 and the input/output electrodes 10, 11, 14 and 15 to the filters 6 and 7 on the front side, respectively.

In order to avoid mutual cross coupling between the branching filter circuit 16 and the receiver filter 7 connected in series, and the branching filter circuit 17 and the transmitter filter 6 connected in series, it is necessary to provide a sufficiently high input impedance for the branching filter circuit 17 and the transmitter filter 6, at a pass band central frequency of the branching filter circuit 16 and the receiver filter 7. The line length of each of the branching filter circuits 16 and 17 is selected for this purpose, and is determined as follows.

Now, considering the cascade connection of the branching filter circuits 16 and the receiver filter 7, a component S₁₁ of a dispersion matrix of S that illustrates characteristics of the network, is given by the following equation:${\text{S}}_{\text{11}} \text{(1) = [rcos θ - cos θ +zsin θ +j(sin θ = zcos θ} \text{- rsin θ)]/[rcos θ + cos θ - zsin θ + j(sin θ +} \text{zcos θ + rsin θ)]}$ wherein θ = B.l, B = 2π/λ, l = line length of the branching filter circuit 17, and r + j.z = input impedance for the transmitter filter.

In order to provide a sufficiently high input impedance for the branching filter circuit 17 and the transmitter filter 6, at a pass band central frequency of the receiver filter 7, it is sufficient for component S₁₁ (1) of the equation (1) to be at a minimum. In other words, the parameter θ may be selected to satisfy the following equation (2):$\text{cos θ = z sin θ}$

In this case, equation (1) can be restated as follows:${\text{S}}_{\text{11}} {\text{(1)=[rcosθ + j(sin θ + z}}^{\text{2}} \text{sin θ - rsin θ )]} {\text{/[rcos θ + j(sin θ + z}}^{\text{2}} \text{sin + rsin θ )]}$

Now, if the input equation (3) is expressed in terms of the impedance (Zin), then${\text{Zin = [(1 + Z}}^{\text{2}} \text{)/r] - j z}$

Thus, it is necessary to provide a sufficiently high impedance for the branching filter circuit 17 and the transmitter filter 6 connected in series, at a pass band of the branching filter circuit 16 and the receiver filter 7 connected in series.

Thus, the branching filter circuit 17 and the transmitting filter 6 connected in series form an attenuator. In this case, in the equation (4), the parameter r is substantially smaller than the unity, i.e. r « 1. Consequently in the equation (4) Zin » 1. Cross coupling between the transmission and reception channels is avoided. It will be understood that in order to provide a sufficiently large real part in the equation (4), the phase angle of Zin has to be zero.

However, according to the structure of the branch filter as mentioned above, the line length of the distributed constant line needs to become so long as to approximate to λ/4, which is a critical drawback to miniaturization of the branching filter and achieving low-cost.

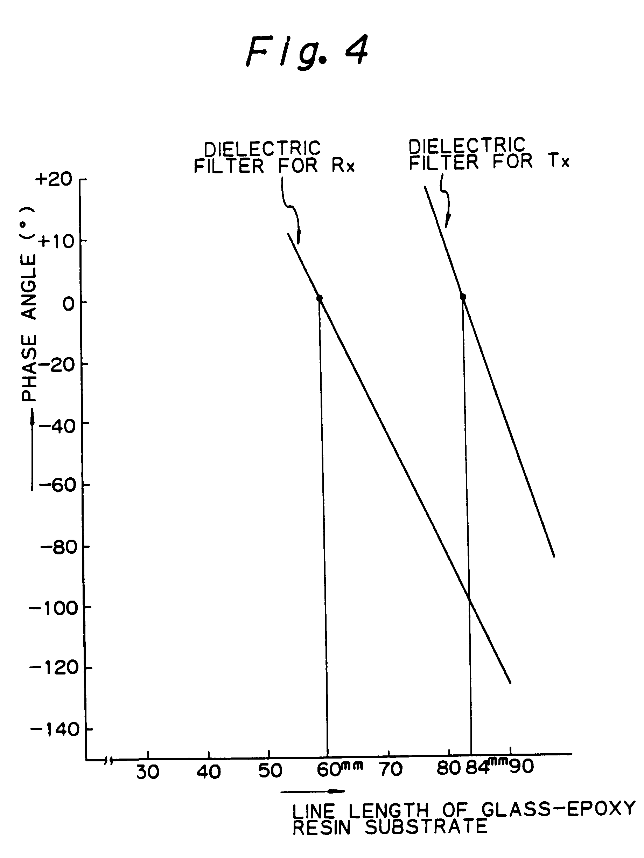

For example, in a case where a conductor having width 1.8 mm is formed on a glass-epoxy resin having thickness 1 mm (dielectric constant 4.8) so as to provide an input impedance of 50 Ω, the relation between line length and the phase angle are as shown in FIG. 4. As apparent from FIG. 4, in order to obtain the phase angle 0°, it is needed to provide line length 60 mm at the receiving side and line length 84 mm at the transmitting side, and thus it would be difficult provide miniaturization of the filter and reduction in cost.

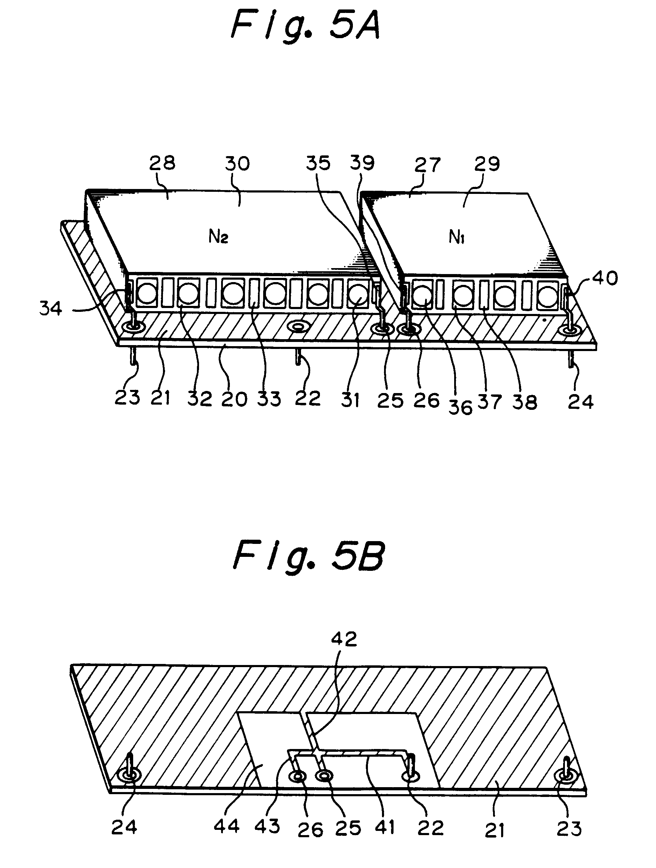

EP-A-0356572 and corresponding Japanese patent laid-open publication 60004/1989 discloses a solution to this problem. FIGS. 5A and 5B show the structure of the branching filter disclosed in the JP laid-open publication. FIG. 5A is a perspective view of such a branching filter, and FIG. 5B is a bottom perspective view of the same. Reference numeral denotes a substrate such as glass-epoxy resin: 21 a ground conductor pattern; 22 an antenna terminal; 23 and 25 terminals of Rx (receiver filter); 24 and 26 terminals of Tx (transmitter filter); 27 a transmitter filter main body; 28 a receiver filter main body; 29 a transmitter filter: 30 a receiver filter; 31 a dielectric resonator of the receiver filter; 32 a frequency regulator pattern of the receiver filter; 33 a coupling amount regulator pattern of the receiver filter; 24 and 25 input/output terminals of the receiver filter; 36 a dielectric resonator of the transmitter filter; 37 a frequency regulator pattern of the transmitter filter: 38 a coupling amount regulator pattern of the transmitter filter; and 39 and 40 input/output terminals of the transmitter filter.

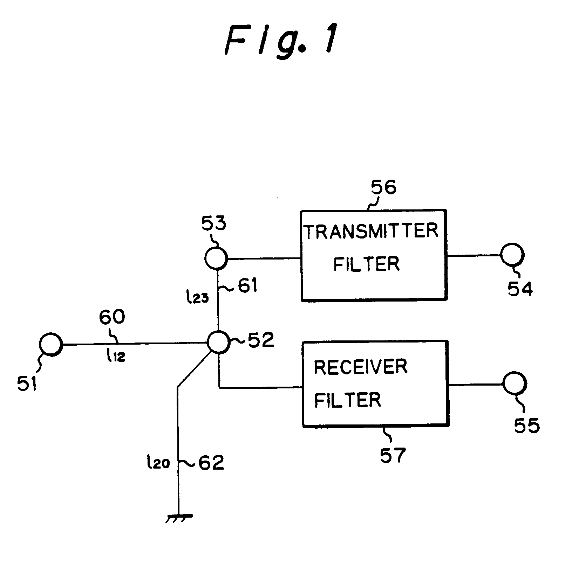

On the back side of the substrate 20, there are formed inductors each comprising a fine line of conductor. More specifically, reference numerals 41, 42 and 43 are directed to inductors L_{AR} 41, L_{RE} 42 and L_{RT} 43, respectively (instead of a distributed constant circuit of the separating or branching filter circuit as shown in FIG 1). Numeral 44 represents a non-conductive portion of the substrate.

The branching filter shown in FIGS. 5A and 5B is, for instance, a branching filter for U.S. AMPS scheme land mobile radiotelephone use, which comprises a transmitter filter (N₁) 29 designed to have a central frequency (fₒ) of 835 MHz and a pass band (BW) of 825 - 845 MHz, and a receiver filter (N₂) 30 with a central frequency fₒ of 880 MHz and BW of 870 - 890 MHz.

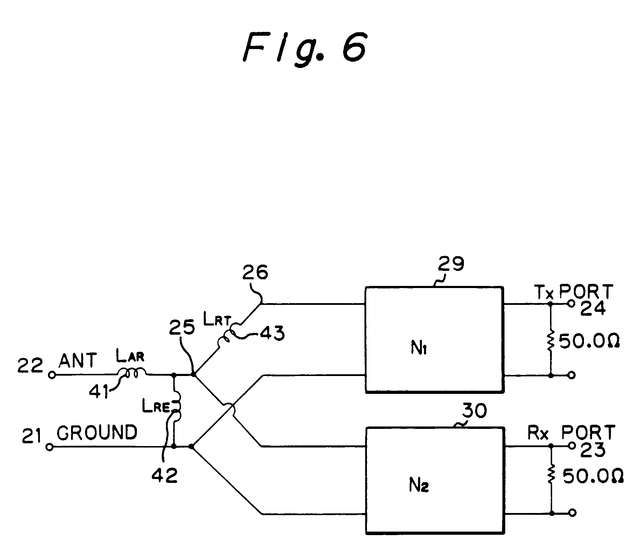

FIG. 6 is a block circuit diagram of the branching filter shown in and described with reference to FIGS 5A and 5B. The mounted filters (N₁) 29 and (N₂) 30 are provided connected as shown.

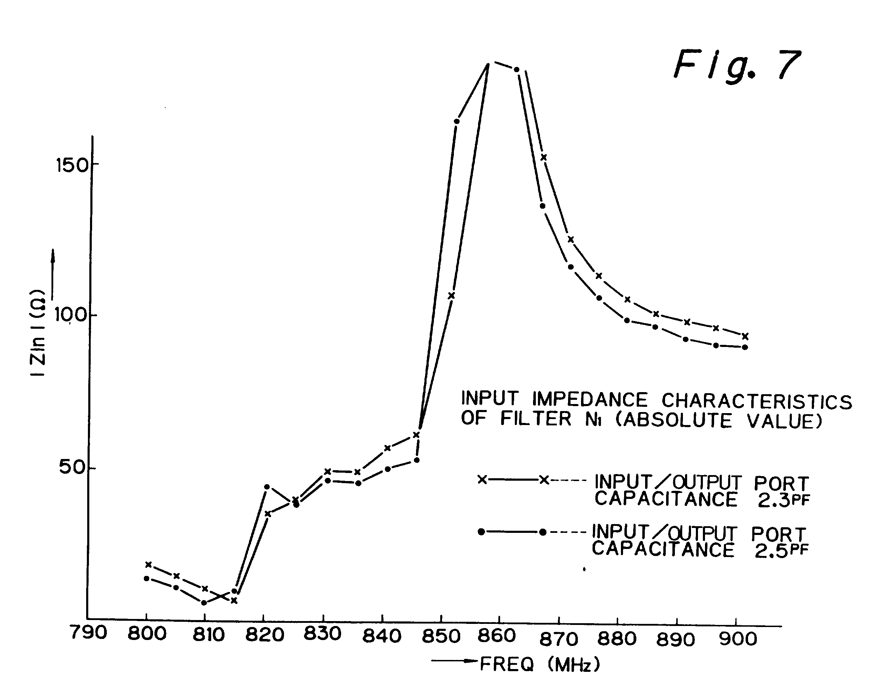

FIG. 7 is a graph of input impedance characteristics (absolute value) of the transmitter filter N₁, in which frequency (MHz) is given on a horizontal axis and an absolute value of input impedance (Ω) is given on a vertical axis. In FIG. 7, two plots are shown, for input/output end capacitances 2.3 pF and 2.5 pF respectively. As apparent from FIG. 7. the input impedance is approximately 50 Ω at 825 - 845 MHz which is the pass band of transmitter filter N₁, and rapidly, increases when exceeding such a pass band.

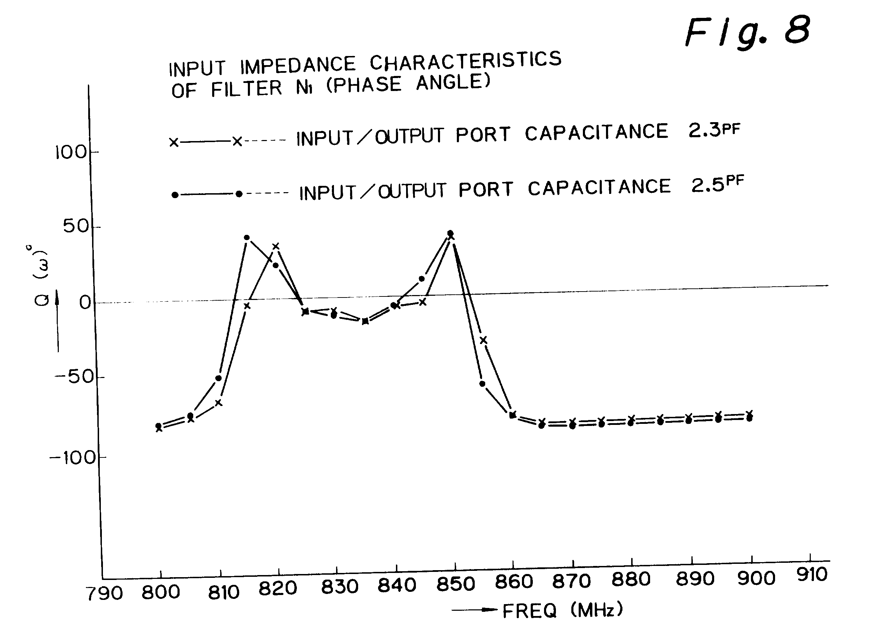

FIG. 8 is a graph of input impedance characteristics (phase angle) of the transmitting filter N₁, in which frequency (MHz) is given on a horizontal axis, and phase angle θ (ω)° is given on a vertical axis. In FIG. 8, the two cases of input/output capacitances of 2.3 pF and 2.5 pF. As apparent from FIG. 8, the phase angle is approximately 0 at 825 - 845 MHz, which is the pass band of the transmitting filter N₁.

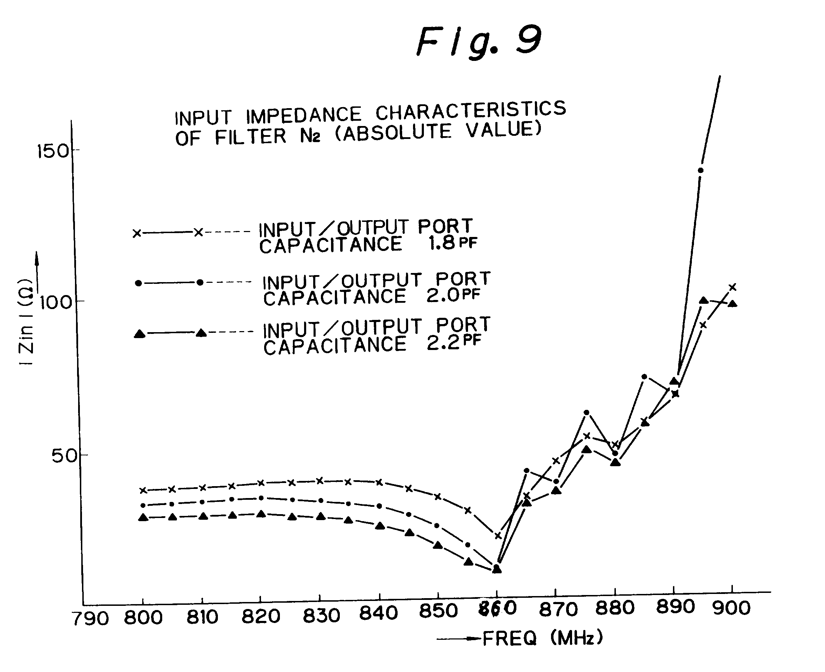

FIG 9 shows input impedance characteristics (absolute value) of the receiving filter N₂, in which frequency (MHz) is given on a horizontal axis, and an absolute value of input impedance (Ω) is given on a vertical axis. In FIG. 9, there are plotted three curves of input/output capacitances 1.8 pF, 2.0 pF and 2.2 pF. As is clear from FIG. 9, the input impedance is approximately 50 Ω at 870 - 890 MHz, which is the pass band of the receiver filter N₂.

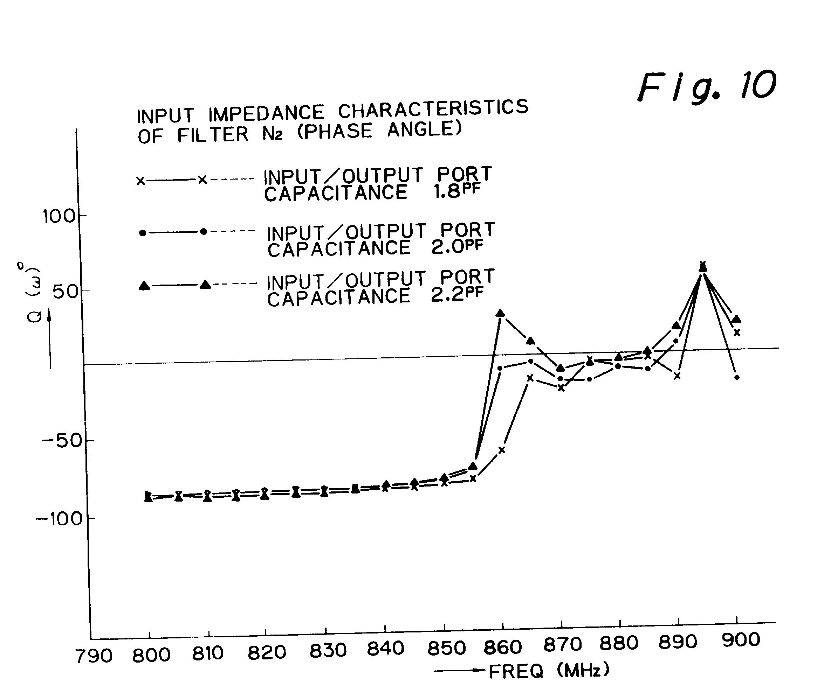

FIG. 10 is a graph in which input impedance characteristics (phase angle) of the receiver filter are plotted with frequency (MHz) given on its horizontal axis and phase angle θ(ω)° given on its vertical axis. In that figure, there are plotted three curves for input/output capacitances of 1.8 pF. 2.0 pF and 2.2 pF. As apparent from the figure, the phase angle is approximately 0 at 870 - 890 MHz which is the pass band of the receiving filter N₂.

It is thus understood that the branching or multiplexer filter as mentioned above is, as shown in FIGS. 5B and 6, provided with the inductors L_{AR} 41, L_{RE} 42 and L_{RT} 43 instead of the distributed constant circuit, as shown in FIG. 1.

The principle of operation of the branching filter of FIG.5 will now be described hereinafter in relation to the operation of the inductors. First, let us consider an instance of no inductors L_{AR} 41, L_{RE} 42 and L_{RT} 43. As a matter of convenience for the description, there will be stated only the central frequencies fₒ = 835 (MHz), fₒ = 880 (MHz) of the respective pass bands B₁ and B₂ of the transmitter and receiver filters N₁ and N₂.

Regarding B₁ [fₒ = 835 (MHz)] And B₂ [fₒ = 880 (MHz)], the following parameters can be derived from FIGS. 7-10:${\text{B}}_{\text{1}} {\text{: r}}_{\text{1}} {\text{= 50.0 x}}_{\text{1}} \text{= 0} {\text{r}}_{\text{2}} {\text{= 0 x}}_{\text{2}} \text{= - j 30}$${\text{B}}_{\text{2}} {\text{: r}}_{\text{1}} {\text{= 0 x}}_{\text{1}} \text{= - j 286.0} {\text{r}}_{\text{2}} {\text{= 50.0 x}}_{\text{2}} \text{= 0}$ where rₙ is the resistance (ohmic) resistance and xₙ is the phase angle for filter n. When the branching filter is constituted by these transmitting and receiving filters, the input impedance Zin and return loss RL, as seen from the ANT terminal 22, are given as follows:${\text{B}}_{\text{1}} \text{: Zin = 13.254 - j 22.068} \text{RL = 3.88 dB}$${\text{B}}_{\text{2}} \text{: Zin = 46.62 - j 12.541} \text{RL = 17.5 dB}$

It is to be understood that these factors are degraded when compared with a case of unity for the transmitting filter N₁ or the receiving filter N₂. Further, it will be understood that it is a problem that x₂ is small for the band B₁. When x₂ is small, the inductor L_{RT} = 5 nH is connected in series to the transmitter filter N₁ so that the input impedance Zin at the band B₁ may approach a reference impedance (Rₒ = 50 Ω ). The input impedance Zin and return loss RL, at that time, are given as follows:$\text{B1 : Zin = 17.9 - j 28.6644} \text{RL = 4.67 dB}$$\text{B2 : Zin = 45.4545 - j 14.341} \text{RL = 16.15 dB}$

The effect of the inductor L_{RE} will now be discussed. If for example L_{RE} = 20 nH, then the input impedance Zin and return loss RL, at B₁ and B₂ after insertion of the inductor L_{RE}, are given as follows:${\text{B}}_{\text{1}} \text{: Zin = 32.2633 - j 31.874} \text{RL = 7.67 dB}$$\text{B2 : Zin = 49.14 - j 6.7125} \text{RL = 23.34 dB}$

It will be understood that the insertion of the inductor L_{RE} serves to provide a relatively small imaginary part of Zin in comparison with a real part of Zin at the respective bands B₁ and B₂.

Next, the effect of the inductor L_{AR} will be described If L_{AR} = 4 nH, the input impedance Zin and return loss RL, at B1 and B2, after insertion of the inductor L_{AR}, are given as follows:${\text{B}}_{\text{1}} \text{: Zin = 32.2633 - j 10.888} \text{RL = 12.01 dB}$${\text{B}}_{\text{2}} \text{: Zin = 49.24 + j 28.834} \text{RL = 11.08 dB}$

It will be understood that insertion of the inductor L_{AR} serves to provide a small imaginary part of Zin on an average basis in the respective bands B₁ and B₂. Thus, it is possible to provide a branching filter satisfying RL > 10 dB, necessary for a land mobile radiotelephone. While the inductors L_{AR}, L_{RE} and L_{RT} were explained by way of example, it is possible to expect a similar operation as far as the tendency of Zin of the filters N₁ and N₂ is not changed.

In a case where the inductors L_{AR}, L_{RE} and L_{RT} are formed on a glass-epoxy resin substrate having the dielectric constant of 4.8 and the thickness of 1.6 mm, the inductance is given by the following relationships, where fₒ = 850 (MHz), l = line length:
1) In case of W (width) = 0.3 mm:$\text{L (nH) = 1. 389 l (mm) - 5.3443}$
   Thus, for the above-mentioned values of the inductors L_{AR}, L_{RE} and L_{RT}, there are obtained the following line lengths:${\text{For L}}_{\text{RT}} \text{= 5 nH, 1 = 7.45 mm}$${\text{For L}}_{\text{RE}} \text{= 20 nH, 1 = 18.25 mm}$${\text{For L}}_{\text{AR}} \text{= 4 nH, 1 = 6.73 mm}$
2) For W (width) = 0. 5 mm:$\text{L (nH) = 1.092 l (mm) - 2. 4726}$
3) For W (width) = 0.7 mm;$\text{L (nH) = 1.0135 1 (mm) - 2. 1753}$

From the foregoing, it can be seen that the lengths of all three of the inductors need to have a preselected individual value to satisfy the requirement that RL > 10dB.

If the inductors are formed on a glass-epoxy, resin substrate having a dielectric constant of 9.3, it is possible to reduce further the line length l.

However, the described conventional branching filters suffer from the following drawbacks:
(1) The branching filter shown in FIG. 3, has a filter circuit that includes a λ/4 line. This structure causes the line of the branching filter circuit to be undesirable long and thus to enlarge the occupied area. Consequently, it is difficult to achieve miniaturisation of the filter and low-cost.
(2) The branching filter shown in FIG. 5 has a filter circuit that includes strip line inductors so that the line length can be shortened as compared with the filter of FIG. 3. However, there is a limitation to the shortening that can be achieved so that the branching filter circuit may still occupy an undesirably large area, limiting the amount of miniaturisation that can be achieved.

It is therefore an object of the present invention to provide a branching filter in which a branching filter circuit occupies a reduced space as compared with the prior art filters described hereinbefore.

According to the present invention, this space is reduced by making lines for connection between filter parts function in a branching filter circuit. In accordance with the invention, this is achieved by means of the characterising features set out in claims 1 and 4 hereinafter.

Features and advantages of the present invention will become more apparent from the consideration of the following detailed description taken in conjunction with the accompanying drawings in which:
FIG. 1 is a schematic block diagram of a preferred embodiment of a branching filter according to the present invention:
FIG. 2 is a top plan view showing an example of mounting the branching filter shown in FIG. 1;
FIGS. 3A and 3B show structures of a conventional branching filter, wherein FIG 3A is a perspective view of the branching filter, and FIG. 3B is a bottom perspective view of the same;
FIG. 4 shows a relationship between the line length and the phase angle;
FIGS. 5A and 5B show structures of another conventional branching filter, FIG. 5A is a perspective view of the branching filter, and FIG. 5B is a bottom perspective view of the same;
FIG 6 is a schematic block diagram, similar to FIG 1, showing a circuit structure of the branching filter shown in FIGS 5A and 5B;
FIG. 7 plots input impedance characteristics (absolute value) of the transmitter filter N₁;
FIG. 8 plots input impedance characteristics (phase angle) of the transmitter filter N₁;
FIG. 9 plots input impedance characteristics (absolute value) of the receiver filter N₂; and
FIG. 10 plots input impedance characteristics (phase angle) of the receiver filter N₂.

FIG. 1 is a block diagram of an illustrative embodiment of the present invention applied to a radio transceiver apparatus. In the figure, reference numeral 51 denotes an antenna or ANT port, which is referred to as an input/output port or terminal: 56 a transmitter filter; 57 a receiver filter; 52 an input port of the receiver filter 57; and 58 an input port of the transmitter filter 56. Although the latter input port 53 functions as a terminal from which signals are outputted, as a matter of convenience, it is referred to as an "input" port hereinafter. The ANT port 51 and the input port 52 are connected by line 60 having a line length l₁₂ the input ports 52 and 53 are connected by line 61 having line a length 1₂₃ and the input port 52 is connected to a reference potential such as ground by line 62 having a line length l₂₀. From the viewpoint of easy treatment, a strip line of 50Ω is often used for the lines 60, 61 and 62 respectively having line lengths l₁₂, l₂₂ and l₂₀.

Thus, the circuit structure shown in FIG. 1 functions as a branching or splitter filter circuit using the lines of connection between parts themselves, without providing a separate dedicated branching filter circuit.

First, for the purpose of simplifying the description, let us consider a case of l₁₂ = ∞. The input admittance Yᵢₙ of the filter circuit taken from the input port 52, is expressed by equation (5).${\text{Y}}_{\text{in}} {\text{= Y}}_{\text{T}} {\text{+ Y}}_{\text{RF}} {\text{+ Y}}_{\text{20}}$ where Y_{T} is a synthetic or combined admittance of the impedance of the line 61 having line length l₂₃ and the input impedance of the transmitter filter 56 and is generally given by equation (6)${\text{Y}}_{\text{T}} \text{=} \frac{{\text{Y}}_{\text{TF}} {\text{cosθ}}_{\text{23}} \text{+} \text{j} {\text{sinθ}}_{\text{23}}}{{\text{cosθ}}_{\text{23}} \text{+} {\text{jY}}_{\text{TF}} {\text{sinθ}}_{\text{23}}}$ where Y_{TF} is an input admittance of the transmitter filter 56, and θ₂₃ is a phase constant (equal to βl₂₃). In addition, Y_{RF} is an input admittance of the receiver filter 57, and Y₂₀ is an input admittance of the line 62 having line length l₂₀ and given by equation (7).${\text{Y}}_{\text{20}} \text{= -} \text{j} \frac{{\text{cosθ}}_{\text{20}}}{{\text{sinθ}}_{\text{20}}}$

Therefore, it is sufficient for a pass band (for example 824.0 MHz - 849.0 MHz, in the case of the AMPS scheme for US land mobile radiotelephones) of the transmitter filter 56 to determine the line length l₂₀ in such a manner that the following equation (8) is satisfied:${\text{Y}}_{\text{RF}} \text{≃} {\text{Y}}_{\text{20}}$

Further, it is sufficient for a pass band (for example 869.0 MHz - 894.0 MHz in the case of AMPS scheme in US land mobile radiotelephone) of the receiver filter 57 to determine the line length l₂₀ so as to satisfy the following equation (9):${\text{Y}}_{\text{T}} {\text{≃ Y}}_{\text{20}}$

However, generally, it is impossible to simultaneously satisfy both of the equations (8) and (9). More specifically, input admittance Yin in a receiving band (869.0 MHz - 894.0 MHz) of a dielectric filter for use in transmitting in the AMPS scheme is generally from FIG. 7, given by$\text{Yin = j} \frac{\text{l}}{\text{100}}$

Further, input admittance Yin in a transmitting band (824.0 MHz - 849.0 MHZ) of a dielectric filter for use in receiving in the AMPS scheme is generally from FIG. 9 given by$\text{Yin} \text{≃} \frac{\text{l}}{\text{20}}$

It will be understood that both equations (8) and (9) cannot simultaneously be satisfied. Usually, if a dielectric filter for use in transmission and a dielectric filter for use in reception are connected in parallel, the impedance in the receiving band of the dielectric filter for use in transmitting is degraded because of an impedance at the transmitting band of the dielectric filter for use in receiving, defined by the equation (11). In view of this, an optimum line length l₂₀ is determined from the expressions (8) and (11).

Thus, in the case of l₁₂ = ∞ in FIG. 1. is possible to construct a branching or multiplexer filter in which the line 62 having line length l₂₀ is provided, and the transmitter and receiver filters 56 and 57 are connected in parallel.

Next, operation of lines 60 and having line lengths l₁₂ and l₂₃ respectively will be described. Generally, in a case where a strip line having line length l is terminated with resistance Rₒ, the F matrix is given by the following relationship (12):

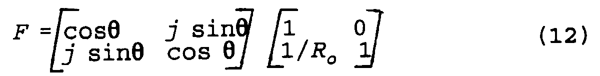

In this case, input impedance Zin is given by the following equation (13):$\text{Zin} \text{=} \frac{\text{cosθ+} \text{j} \frac{\text{sinθ}}{{\text{R}}_{\text{o}}}}{\text{j} \text{sinθ+} \frac{\text{cosθ}}{{\text{R}}_{\text{o}}}}$

Therefore, it is understood that the input impedance Zin is varied in dependence upon a change in line length 1, since θ is given by β;l. This means approximately that lines 60 and 62 having line lengths l₁₂ and l₂₃ respectively, simply make the impedance level move upwards or downwards from a reference value, depending on their length.

In order to use the line 60 having line length l₁₂ as a part of the branching filter, it is sufficient that the impedance, of the transmitting and receiving filters 56 and 57 as seen from the input port 52 shown in FIG. 1 is corrected to a suitable reference value.

Input impedance Zᵢₙ to said transmitted filter 56 and said receiver filter 57 from the input/output port 51 is expressed by the following equation (14), which can be obtained by substitution of 1/Rₒ = Yᵢₙ and θ = θ₁₂ in equation (13),${\text{Z}}_{\text{in}} \text{=} \frac{{\text{cosθ}}_{\text{12}} \text{+} {\text{jY}}_{\text{in}} {\text{sinθ}}_{\text{12}}}{\text{j} {\text{sinθ}}_{\text{12}} \text{+} {\text{Y}}_{\text{in}} {\text{cosθ}}_{\text{12}}}$ where θ₁₂ is a phase constant of the first line 60 (conductive strip) having line length l₁₂. The input impedance Zᵢₙ is adjusted by varying at least one component of the input admittance Y_{TF} or Y_{RF} contained in the admittance Yᵢₙ, in such a manner that a return loss seen from the input/output port 51 is increased.

Regarding the line 61 having line length l₂₃, this alters the value of the input impedance of the transmitter filter 56. Thus in the case of a presence of the line 61 having line length l₂₃, it is sufficient that the input impedance of the transmitter filter 56 is previously corrected to take account of the length of the line 61.

Thus, from the foregoing it will be understood that the lines 60 and 61 can be of arbitrary length, but that the length of line 62 needs to be selected according to equations (8) and (11) to optimise the impedance in both the transmission and reception bands. For the AMPS scheme, as discussed hereinbefore, this implies a return loss for both the transmission and reception bands that exceeds a predetermined level, which in the AMPS scheme is 10 dB.

Thus, it is understood that regulation of the transmitting and receiving filters 56 and 57 with the lines 60 and 61 having line lengths l₁₂ and l₂₃, respectively, taking account of them as a part of the branching filter, makes it possible to reduce deterioration of filter characteristics due to line lengths l₁₂ and l₂₃, and also to provide a branching circuit that occupies a small area.

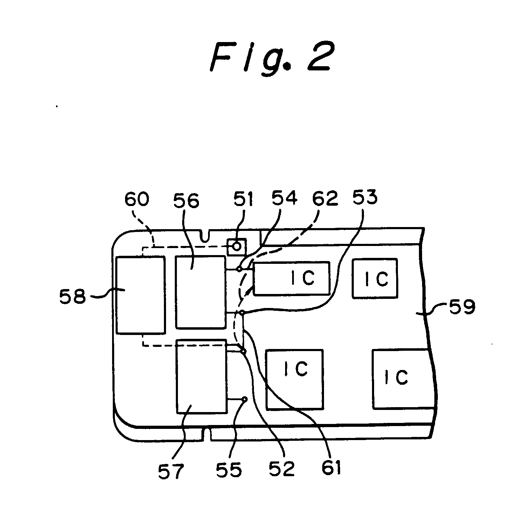

FIG. 2 is a top plan view showing an example of how to mount the branching or multiplexer filter shown in and described with reference to FIG. 1. As shown in FIG 2, there are provided on a substrate 59 of synthetic resin such as glass-epoxy resin or alumina, the ANT port 51 to which an external or utility circuit is connected, the transmitter filter 56, the receiver filter 57, a changeover switch 58, the input and output ports 52 and 55 of the receiver filter 57, and the input and output ports 53 and 54 of the transmitter filter 56. The line 60 having line length l₁₂ extending from the ANT port 51 through the changeover switch 58 to input port 52, the line 61 having line length l₂₃ extending from the input port 52 to the input port 53, and the line 62 having line length extending from the input port 52 to ground, correspond to the lines 60, 61 and 62 having line lengths l₁₂, l₂₃ and l₂₀ depicted in FIG. 1, respectively. These lines are formed from an intermediate layer of conductor on the substrate 59. It is thus to be understood that according to the present invention, no specific area is occupied on the substrate 59 of the multiplexer filter by a discrete or dedicated branching filter circuit, which would have to be specifically configured in the prior art.

As described above, according to the present invention, when a branching filter is implemented by using transmitting and a receiving filter lines for connecting both of the filters with a utility or external circuit, they function as a part of a branching filter circuit. Thus, no extra area is required on the substrate for a dedicated branching filter circuit which would otherwise be required. Accordingly it is possible to provide an inexpensive miniaturised branching filter very useful for miniaturised radio apparatus manufactured at a reduced cost.

## Claims

1. A branching filter comprising:
an input/output port (51);
a transmitter filter (56) with an output port (53) and a receiver filter (57) with an input port (52), each said filter being a dielectric filter; and
a branching filter circuit coupling said filters together, including:
a first conductive strip line (60) having a first line length *l*₁₂ coupling said input/output port (51) with said receiver filter port (52);
a second conductive strip line (61) having a second line length *l*₂₃ coupled between said receiver filter port (52) and said transmitter filter port (53); and
a third conductive strip line (62) having a third line length *l*₂₀ coupled between said receiver filter port (52) and a reference potential, **characterised in that**
said branching filter is configured so that for port (51) being open circuit an input admittance Yᵢₙ looking toward said transmitter filter (56) and said receiver filter (57) from the input/output port (51) is expressed by the following equation,${\text{Y}}_{\text{in}} {\text{= Y}}_{\text{T}} {\text{+ Y}}_{\text{RF}} {\text{+ Y}}_{\text{20}}$
wherein
Y_{T} is a synthetic admittance of input admittance of the second conductive strip line (61),
Y_{RF} is the input admittance of said receiver filter (57), and
Y₂₀ is the input admittance of the third line (62),
Y_{T} being expressed by the following equation,${\text{Y}}_{\text{T}} \text{=} \frac{{\text{Y}}_{\text{TF}} {\text{cosθ}}_{\text{23}} \text{+} \text{j} {\text{sinθ}}_{\text{23}}}{{\text{cosθ}}_{\text{23}} \text{+} {\text{jY}}_{\text{TF}} {\text{sinθ}}_{\text{23}}}$
Y_{TF} is the input admittance of said transmitter filter (56)
θ₂₃ is the phase constant of the second line (61), and
Y₂₀ being expressed by the following equation,${\text{Y}}_{\text{20}} \text{= -} \text{j} \frac{{\text{cosθ}}_{\text{20}}}{{\text{sinθ}}_{\text{20}}}$
where θ₂₀ is a phase constant of the third line (62);
wherein the input admittance Y_{RF} of said receiver filter (57) at a pass band of said transmitter filter (56) is expressed by Y_{RF} ≃ Y₂₀, and wherein the synthetic admittance Y_{T} at a pass band of said receiver filter (57) is expressed by Y_{T} ≃ Y₂₀, the length *l*₂₀ of the third line (62) being such that a selected one of Y_{RF} ≃ Y₂₀ and Y_{T} ≃ Y₂₀ is satisfied; and
wherein the input impedance Zᵢₙ looking toward said transmitter filter (56) and said receiver filter (57) from the input/output port (51) is expressed by the following equation,${\text{Z}}_{\text{in}} \text{=} \frac{{\text{cosθ}}_{\text{12}} \text{+} {\text{jY}}_{\text{in}} {\text{sinθ}}_{\text{12}}}{\text{j} {\text{sinθ}}_{\text{12}} \text{+} {\text{Y}}_{\text{in}} {\text{cosθ}}_{\text{12}}}$ where θ₁₂ is a phase constant of the first line (60),
the input admittance Y_{TF} contained in the admittance Yᵢₙ being such that the input impedance Zᵢₙ is increased at a receiving frequency band, and the input admittance Y_{RF} contained in the admittance Yᵢₙ being such that the input impedance Zᵢₙ is increased at a transmitting frequency band.

2. A branching filter according to claim 1, wherein said input impedance Zᵢₙ is such that a return loss from the input/output port (51) is larger than 10 db.

3. A branching filter according to claim 1 or 2, further comprising an insulative substrate, said input/output port (51), said transmitter (56), said receiver filter (57) and said branching filter circuit are mounted thereon.

4. A method of constructing a branching filter comprising a transmitter filter (56) having input and output ports, a receiver filter (57) having input and output ports, an input/output port (51), and a reference potential said method comprising the steps of:
coupling a first conductive strip line (60) having a first line length *l*₁₂ between said input/output port (51) and the input port (52) of said receiver filter (57);
coupling a second conductive strip line (61) having a second line length *l*₂₃ between the input port (52) of said receiver filter (57) and the output port (53) of said transmitter filter (56); and
coupling a third conductive strip line (62) having a third line length *l*₂₀ between said input port (52) of said receiver filter (57) and the reference potential, **characterised by** configuring the filters and the first, second, and third conductive strip lines so that for input/output port (51) being open circuit, an input admittance Yᵢₙ looking toward said transmitter filter (56) and said receiver filter (57) from the input/output port (51) is expressed by the following equation,${\text{Y}}_{\text{in}} {\text{= Y}}_{\text{T}} {\text{+ Y}}_{\text{RF}} {\text{+ Y}}_{\text{20}}$
wherein Y_{T} is a synthetic admittance of input admittance of the second conductive strip line (61),
Y_{RF} is the input admittance of said receiver filter (57), and
Y₂₀ is the input admittance of the third line (62),
Y_{T} being expressed by the following equation,${\text{Y}}_{\text{T}} \text{=} \frac{{\text{Y}}_{\text{TF}} {\text{cosθ}}_{\text{23}} \text{+} \text{j} {\text{sinθ}}_{\text{23}}}{{\text{cosθ}}_{\text{23}} \text{+} {\text{jY}}_{\text{TF}} {\text{sinθ}}_{\text{23}}}$ wherein
Y_{TF} is the input admittance of said transmitter filter (56)
θ₂₃ is the phase constant of the second line (61), and
Y₂₀ being expressed by the following equation,${\text{Y}}_{\text{20}} \text{= -} \text{j} \frac{{\text{cosθ}}_{\text{20}}}{{\text{sinθ}}_{\text{20}}}$
where θ₂₀ is a phase constant of the third line (62);
wherein the input admittance Y_{RF} of said receiver filter (57) at a pass band of said transmitter filter (56) is expressed by Y_{RF} ≃ Y₂₀, and wherein the synthetic admittance Y_{T} at a pass band of said receiver filter (57) is expressed by Y_{T} ≃ Y₂₀, the length *l*₂₀ of the third line (62) being such that a selected one of Y_{RF} ≃ Y₂₀ and Y_{T} ≃ Y₂₀ is satisfied; and
wherein the input impedance Zin looking toward 5 said transmitter filter (56) and said receiver filter (57) from the input /output port (51) is expressed by the following equation,${\text{Z}}_{\text{in}} \text{=} \frac{{\text{cosθ}}_{\text{12}} \text{+} {\text{jY}}_{\text{in}} {\text{sinθ}}_{\text{12}}}{\text{j} {\text{sinθ}}_{\text{12}} \text{+} {\text{Y}}_{\text{in}} {\text{cosθ}}_{\text{12}}}$ where θ₁₂ is a phase constant of the first line (60),
adjusting the input admittance Y_{TF} contained in the admittance Yᵢₙ in such a manner that the input impedance Zᵢₙ is increased at a receiving frequency band; and
adjusting the input admittance Y_{RF} contained in the admittance Yᵢₙ in such a manner that the input impedance Zᵢₙ is increased at a transmitting frequency band.

## Patentansprüche

1. Sende-Empfangs-Weiche, die folgendes aufweist:
einen Ein-/Ausgangs-Port (51);
ein Senderfilter (56) mit einem Ausgangs-Port (53) und ein Empfängerfilter (57) mit einem Eingangs-Port (52), wobei jedes dieser Filter ein dielektrisches Filter ist; und
einen Sende-Empfangs-Weichen-Schaltkreis, der die Filter miteinander koppelt, enthaltend:
eine erste leitende Streifenleitung (60) mit einer ersten Leitungslänge *l*₁₂, die den Ein-/Ausgangs-Port (51) mit dem Empfängerfilter-Port (52) koppelt; und
eine zweite leitende Streifenleitung (61) mit einer zweiten Leitungslänge *l*₂₃, die zwischen den Empfängerfilter-Port (52) und den Senderfilter-Port (53) gekoppelt ist; und
eine dritte leitende Streifenleitung (62) mit einer dritten Leitungslänge *l*₂₀, die zwischen den Empfängerfilter-Port (52) und ein Bezugspotential gekoppelt ist, **dadurch gekennzeichnet, daß**
die Sende-Empfangs-Weiche so ausgeführt ist, daß, wenn der Port (51) im Leerlauf ist, eine Eingangsadmittanz Yᵢₙ vom Ein-/Ausgangs-Port (51) aus in Richtung auf das Senderfilter (56) und das Empfängerfilter (57) durch die folgende Gleichung ausgedrückt wird,${\text{Y}}_{\text{in}} {\text{= Y}}_{\text{T}} {\text{+Y}}_{\text{RF}} {\text{+Y}}_{\text{20}}$ wobei
Y_{T} eine Gesamtadmittanz der Eingangsadmittanz der zweiten leitenden Streifenleitung (61) ist,
Y_{RF} die Eingangsadmittanz des Empfängerfilters (57) ist und
Y₂₀ die Eingangsadmittanz der dritten Leitung (62) ist,
Y_{T} durch die folgende Gleichung ausgedrückt wird,${\text{Y}}_{\text{T}} \text{=} \frac{{\text{Y}}_{\text{TF}} {\text{cosθ}}_{\text{23}} \text{+} \text{j} {\text{sinθ}}_{\text{23}}}{{\text{cosθ}}_{\text{23}} \text{+} {\text{jY}}_{\text{TF}} {\text{sinθ}}_{\text{23}}}$ wobei
Y_{TF} die Eingangsadmittanz des Senderfilters (56) ist,
θ₂₃ die Phasenkonstante der zweiten Leitung (61) ist und
Y₂₀ durch die folgende Gleichung ausgedrückt wird,${\text{Y}}_{\text{20}} \text{= -} \text{j} \frac{{\text{cosθ}}_{\text{20}}}{{\text{sinθ}}_{\text{20}}}$ wobei θ₂₀ eine Phasenkonstante der dritten Leitung (62) ist;
wobei die Eingangsadmittanz Y_{RF} des Empfängerfilters (57) in einem Durchlaßbereich des Senderfilters (56) durch Y_{RF} ≃ Y₂₀ ausgedrückt wird und wobei die Gesamtadmittanz Y_{T} in einem Durchlaßbereich des Empfängerfilters (57) durch Y_{T} ≃ Y₂₀ ausgedrückt wird, wobei die Länge *l*₂₀ der dritten Leitung (62) derart ist, daß wahlweise Y_{RF} ≃ Y₂₀ oder Y_{T} ≃ Y₂₀ erfüllt ist; und
wobei die Eingangsimpedanz Zᵢₙ vom Ein-/Ausgangs-Port (51) aus in Richtung auf das Senderfilter (56) und das Empfängerfilter (57) durch die folgende Gleichung ausgedrückt wird,${\text{Z}}_{\text{in}} \text{=} \frac{{\text{cosθ}}_{\text{12}} \text{+} {\text{jY}}_{\text{in}} {\text{sinθ}}_{\text{12}}}{\text{j} {\text{sinθ}}_{\text{12}} \text{+} {\text{Y}}_{\text{in}} {\text{cosθ}}_{\text{12}}}$ wobei θ₁₂ eine Phasenkonstante der dritten Leitung (60) ist,
daß die in der Admittanz Yᵢₙ enthaltene Eingangsadmittanz Y_{TF} derart ist, daß die Eingangsimpedanz Zᵢₙ in einem Empfangsfrequenzbereich erhöht wird, und daß die in der Admittanz Yᵢₙ enthaltene Eingangsadmittanz Y_{RF} derart ist, daß die Eingangsimpedanz Zᵢₙ in einem Sendefrequenzbereich erhöht wird.

2. Sende-Empfangs-Weiche gemäß Anspruch 1, wobei die Eingangsimpedanz Zᵢₙ derart ist, daß eine Reflexionsdämpfung des Ein-/Ausgangs-Ports (51) größer als 10 dB ist.

3. Sende-Empfangs-Weiche gemäß Anspruch 1 oder 2, die weiterhin ein isolierendes Substrat aufweist, auf dem der Ein-/Ausgangs-Port (51), das Senderfilter (56), das Empfängerfilter (57) und der Sende-Empfangs-Weichen-Schaltkreis angebracht sind.

4. Verfahren zum Aufbau einer Sende-Empfangs-Weiche, die ein Senderfilter (56) mit Eingangs- und Ausgangs-Ports, ein Empfängerfilter (57) mit Eingangs- und Ausgangs-Ports, einen Ein-/Ausgangs-Port (51) und ein Bezugspotential aufweist, wobei das Verfahren folgende Verfahrensschritte aufweist:
eine erste leitende Streifenleitung (60) mit einer ersten Leitungslänge *l*₁₂ zwischen den Ein-/Ausgangs-Port (51) und den Eingangs-Port (52) des Empfängerfilters (57) zu koppeln;
eine zweite leitende Streifenleitung (61) mit einer zweiten Leitungslänge *l*₂₃ zwischen den Eingangs-Port (52) des Empfängerfilters (57) und den Ausgangs-Port (53) des Senderfilters (56) zu koppeln; und
eine dritte leitende Streifenleitung (62) mit einer dritten Leitungslänge *l*₂₀ zwischen den Eingangs-Port (52) des Empfängerfilters (57) und das Bezugspotential zu koppeln, **dadurch gekennzeichnet, daß** die Filter und die erste, die zweite und die dritte leitende Streifenleitung so ausgeführt werden, daß, wenn der Ein-/Ausgangs-Port (51) im Leerlauf ist, eine Eingangsadmittanz Yᵢₙ vom Ein-/Ausgangs-Port (51) aus in Richtung auf das Senderfilter (56) und das Empfängerfilter (57) durch die folgende Gleichung ausgedrückt wird,${\text{Y}}_{\text{in}} {\text{= Y}}_{\text{T}} {\text{+ Y}}_{\text{RF}} {\text{+ Y}}_{\text{20}}$ wobei Y_{T} eine Gesamtadmittanz der Eingangsadmittanz der zweiten leitenden Streifenleitung (61) ist,
Y_{RF} die Eingangsadmittanz des Empfängerfilters (57) ist und
Y₂₀ die Eingangsadmittanz der dritten Leitung (62) ist,
Y_{T} durch die folgende Gleichung ausgedrückt wird,${\text{Y}}_{\text{T}} \text{=} \frac{{\text{Y}}_{\text{TF}} {\text{cosθ}}_{\text{23}} \text{+} \text{j} {\text{sinθ}}_{\text{23}}}{{\text{cosθ}}_{\text{23}} \text{+} {\text{jY}}_{\text{TF}} {\text{sinθ}}_{\text{23}}}$ wobei
Y_{TF} die Eingangsadmittanz des Senderfilters (56) ist,
θ₂₃ die Phasenkonstante der zweiten Leitung (61) ist und
Y₂₀ durch die folgende Gleichung ausgedrückt wird,${\text{Y}}_{\text{20}} \text{= -} \text{j} \frac{{\text{cosθ}}_{\text{20}}}{{\text{sinθ}}_{\text{20}}}$ wobei θ₂₀ eine Phasenkonstante der dritten Leitung (62) ist;
wobei die Eingangsadmittanz Y_{RF} des Empfängerfilters (57) in einem Durchlaßbereich des Senderfilters (56) durch Y_{RF} ≃ Y₂₀ ausgedrückt wird und wobei die Gesamtadmittanz Y_{T} in einem Durchlaßbereich des Empfängerfilters (57) durch Y_{T} ≃ Y₂₀ ausgedrückt wird, wobei die Länge *l*₂₀ der dritten Leitung (62) derart ist, daß wahlweise Y_{RF} ≃ Y₂₀ oder Y_{T} ≃ Y₂₀ erfüllt ist; und
wobei die Eingangsimpedanz Zᵢₙ vom Ein-/Ausgangs-Port (51) aus in Richtung auf das Senderfilter (56) und das Empfängerfilter (57) durch die folgende Gleichung ausgedrückt wird,${\text{Z}}_{\text{in}} \text{=} \frac{{\text{cosθ}}_{\text{12}} \text{+} {\text{jY}}_{\text{in}} {\text{sinθ}}_{\text{12}}}{\text{j} {\text{sinθ}}_{\text{12}} \text{+} {\text{Y}}_{\text{in}} {\text{cosθ}}_{\text{12}}}$ wobei *θ*₁₂ eine Phasenkonstante der dritten Leitung (60) ist,
daß die in der Admittanz Yᵢₙ enthaltene Eingangsadmittanz Y_{TF} derart eingestellt wird, daß die Eingangsimpedanz Zᵢₙ in einem Empfangsfrequenzbereich erhöht wird, und
daß die in der Admittanz Yᵢₙ enthaltene Eingangsadmittanz Y_{RF} derart eingestellt wird, daß die Eingangsimpedanz Zᵢₙ in einem Sendefrequenzbereich erhöht wird.

## Revendications

1. Filtre d'aiguillage comprenant :
une borne d'entrée/sortie (51) ;
un filtre d'émetteur (56) comportant une borne de sortie (53) et un filtre de récepteur (57) comportant une borne d'entrée (52), chacun desdits filtres étant un filtre diélectrique; et
un circuit de filtre d'aiguillage couplant lesdits filtres entre eux, comprenant :
une première ligne en forme de bande conductrice (60) possédant une première longueur de ligne l₁₂ couplant ladite borne d'entrée/sortie (51) à ladite borne (52) du filtre de récepteur;
une deuxième ligne en forme de bande conductrice (61) possédant une seconde longueur de ligne l₂₃ et branchée entre ladite borne (52) du filtre de récepteur et ladite borne (53) du filtre d'émetteur; et
une troisième ligne en forme de bande conductrice (62) possédant une troisième longueur de ligne l₂₀ et branchée entre ladite borne (52) du filtre de récepteur et un potentiel de référence, caractérisé en ce que
ledit filtre d'aiguillage est configuré de telle sorte que lorsque la borne (51) est en circuit ouvert, une admittance d'entrée Yᵢₙ, lorsqu'on regarde en direction dudit filtre d'émetteur (56) et dudit filtre de récepteur (57) à partir de la borne d'entrée/sortie (51), est exprimée par la relation suivante${\text{Y}}_{\text{in}} {\text{= Y}}_{\text{T}} {\text{+ Y}}_{\text{RF}} {\text{+ Y}}_{\text{20}}$ dans laquelle
Y_{T} est une admittance synthétique de l'admittance d'entrée de la deuxième ligne en forme de bande conductrice (61),
Y_{RF} est l'admittance d'entrée dudit filtre de récepteur (57), et
Y₂₀ est l'admittance d'entrée de la troisième ligne (62),
Y_{T} étant exprimé par la relation suivante${\text{Y}}_{\text{T}} \text{=} \frac{{\text{Y}}_{\text{TF}} {\text{cosθ}}_{\text{23}} {\text{+jsinθ}}_{\text{23}}}{{\text{cosθ}}_{\text{23}} {\text{+jY}}_{\text{TF}} {\text{sinθ}}_{\text{23}}}$
dans laquelle
Y_{TF} est l'admittance d'entrée dudit filtre d'émetteur (56),
θ₂₃ est la constante de phase de la deuxième ligne (61), et
Y₂₀ est exprimée par la relation suivante${\text{Y}}_{\text{20}} \text{= -j} \frac{{\text{cosθ}}_{\text{20}}}{{\text{sinθ}}_{\text{20}}}$
θ₂₀ étant une constante de phase de la troisième ligne (62);
et dans lequel l'admittance d'entrée Y_{RF} dudit filtre de récepteur (57) pour une bande passante dudit filtre d'émetteur (56) est exprimée par Y_{RF} ∼ Y₂₀, et dans lequel l'admittance synthétique Y_{T} pour une bande passante dudit filtre de récepteur (57) est exprimée par Y_{T} ∼ Y₂₀, la longueur l₂₀ de la troisième ligne (62) étant telle que l'un de Y_{RF} ∼ Y₂₀ et Y_{T} ∼ Y₂₀ est satisfait; et
dans lequel l'impédance d'entrée Zᵢₙ, lorsqu'on regarde en direction dudit filtre d'émetteur (56) et dudit filtre de récepteur (57) à partir de la borne d'entrée/sortie (51), est exprimée par la relation suivante${\text{Z}}_{\text{in}} \text{=} \frac{{\text{cosθ}}_{\text{12}} {\text{+jY}}_{\text{in}} {\text{sinθ}}_{\text{12}}}{{\text{jsinθ}}_{\text{12}} {\text{+Y}}_{\text{in}} {\text{cosθ}}_{\text{12}}}$
dans laquelle θ₁₂ est une constante de phase de la première ligne (60),
l'admittance d'entrée Y_{TF} contenue dans l'admittance Yᵢₙ étant telle que l'impédance d'entrée Zᵢₙ est accrue dans une bande de fréquences de réception, et l'admittance d'entrée Y_{RF} contenue dans l'admittance Yᵢₙ étant telle que l'impédance d'entrée Zᵢₙ est accrue dans une bande de fréquences d'émission.

2. Filtre d'aiguillage selon la revendication 1, dans lequel ladite impédance d'entrée Zᵢₙ est telle qu'une perte de retour à partir de la borne d'entrée/sortie (51) est supérieure à 10 dB.

3. Filtre d'aiguillage selon la revendication 1 ou 2, comprenant en outre un substrat isolant, ladite borne d'entrée/sortie (51), ledit émetteur (56), ledit filtre de récepteur (57) et ledit circuit de filtre d'aiguillage étant disposés sur le substrat.

4. Procédé pour construire un filtre d'aiguillage comprenant un filtre d'émetteur (56) possédant des bornes d'entrée et de sortie, un filtre de récepteur (57) possédant des bornes d'entrée et de sortie, une borne d'entrée/sortie (51) et un potentiel de référence, ledit procédé comprenant les étapes consistant à :
coupler une première ligne en forme de bande conductrice (60) possédant une première longueur de ligne l₁₂ entre ladite borne d'entrée/sortie (51) et la borne d'entrée (52) dudit filtre de récepteur (57);
coupler une deuxième ligne en forme de bande conductrice (61) possédant une seconde longueur de ligne l₂₃ entre la borne d'entrée (52) dudit filtre de récepteur (57) et la borne de sortie (53) dudit filtre d'émetteur (56) ; et
coupler une troisième ligne en forme de bande conductrice (62) possédant une troisième longueur de ligne l₂₀ entre ladite borne d'entrée (51) dudit filtre de récepteur (57) et le potentiel de référence,
caractérisé par la configuration des filtres et des première, deuxième et troisième lignes en forme de bandes conductrices de telle sorte que lorsque la borne d'entrée/sortie (51) est en circuit ouvert, une admittance d'entrée Yᵢₙ, lorsqu'on regarde en direction dudit filtre d'émetteur (56) et dudit filtre de récepteur (57) à partir de la borne d'entrée/sortie (51), est exprimée par la relation suivante${\text{Y}}_{\text{in}} {\text{= Y}}_{\text{T}} {\text{+ Y}}_{\text{RF}} {\text{+ Y}}_{\text{20}}$
Y_{T} étant une admittance synthétique de l'admittance d'entrée de la deuxième ligne en forme de bande conductrice (61),
Y_{RF} est l'admittance d'entrée dudit filtre de récepteur (57), et
Y₂₀ est l'admittance d'entrée de la troisième ligne (62),
Y_{T} étant exprimée par la relation suivante${\text{Y}}_{\text{T}} \text{=} \frac{{\text{Y}}_{\text{TF}} {\text{cosθ}}_{\text{23}} {\text{+jsinθ}}_{\text{23}}}{{\text{cosθ}}_{\text{23}} {\text{+jY}}_{\text{TF}} {\text{sinθ}}_{\text{23}}}$ dans laquelle
Y_{TF} est l'admittance d'entrée dudit filtre d'émetteur (56),
θ₂₃ est la constante de phase de la deuxième ligne (61), et
Y₂₀ est exprimée par la relation suivante${\text{Y}}_{\text{20}} \text{= -j} \frac{{\text{cosθ}}_{\text{20}}}{{\text{sinθ}}_{\text{20}}}$
θ₂₀ étant une constante de phase de la troisième ligne (62);
et dans lequel l'admittance d'entrée Y_{RF} dudit filtre de récepteur (57) pour une bande passante dudit filtre d'émetteur (56) est exprimée par Y_{RF} ∼ Y₂₀, et dans lequel ladite admittance synthétique Y_{T} pour une bande passante dudit filtre de récepteur (57) est exprimée par Y_{T} ∼ Y₂₀, la longueur l₂₀ de la troisième ligne (62) étant telle que l'un de Y_{RF} ∼ Y₂₀ et Y_{T} ∼ Y₂₀ est satisfait; et
dans lequel l'impédance d'entrée Zᵢₙ, lorsqu'on regarde en direction dudit filtre d'émetteur (56) et dudit filtre de récepteur (57) à partir de la borne d'entrée/sortie (51), est exprimée par la relation suivante${\text{Z}}_{\text{in}} \text{=} \frac{{\text{cosθ}}_{\text{12}} {\text{+jY}}_{\text{in}} {\text{sinθ}}_{\text{12}}}{{\text{jsinθ}}_{\text{12}} {\text{+Y}}_{\text{in}} {\text{cosθ}}_{\text{12}}}$
dans laquelle θ₁₂ est une constante de phase de la première ligne (60),
régler l'admittance d'entrée Y_{TF} contenue dans l'admittance Yᵢₙ de telle sorte que l'impédance d'entrée Zᵢₙ augmente dans une bande de fréquences de réception; et
régler l'admittance d'entrée Y_{RF} contenue dans l'admittance Yᵢₙ de telle sorte que l'impédance d'entrée Zᵢₙ augmente dans une bande de fréquences d'émission.
